# EUROPÄISCHE PATENTSCHRIFT

(11) **EP 2 795 736 B1**
(45) Veröffentlichungstag und Bekanntmachung des Hinweises auf die Patenterteilung: **23.09.2020**
(21) Anmeldenummer: 12798188.4
(22) Anmeldetag: 14.11.2012
(51) Int. Cl.: H01R 13/52, H01R 12/55

(54) **ELEKTRISCHER STECKVERBINDER UND EINE DIESBEZÜGLICHE ANORDNUNG MIT EINEM GEHÄUSE**
ELECTRICAL PLUG-TYPE CONNECTOR AND AN ASSOCIATED ARRANGEMENT COMPRISING A HOUSING
CONNECTEUR ÉLECTRIQUE À FICHES ET DISPOSITIF CONNEXE COMPORTANT UN BOÎTIER

(30) Priorität: 19.12.2011 DE 102011089081
(43) Veröffentlichungstag der Anmeldung: 29.10.2014
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2012/072611
(87) Internationale Veröffentlichungsnummer: WO 2013/092015

(56) Entgegenhaltungen:
- WO-A1-2009/130156
- DE-A1- 19 803 358
- JP-A- H09 186 475
- US-A- 5 735 697

## Beschreibung

### Stand der Technik

In Automatikgetrieben von modernen Kraftfahrzeugen sind vielfach die Getriebesteuermodule innerhalb des Automatikgetriebes angeordnet. Um diese Getriebesteuermodule mit elektrischen Anschlussleitungen für Spannungsversorgung, Signal- und Busleitungen elektrisch leitend zu verbinden, werden von dem Getriebesteuermodul elektrische Leitungen zu einem elektrischen Steckverbinder geführt, der in einem Durchbruch eines das Automatikgetriebe umgebenden Getriebegehäuses angeordnet ist. Das Getriebegehäuse begrenzt einen mit Automatikgetriebeöl gefüllten Innenraum von einem das Automatikgetriebe umgebenden Außenraum. Der elektrische Steckverbinder ist von dem Außenraum mittels eines elektrischen Gegensteckverbinders elektrisch kontaktierbar. Der in dem Durchbruch angeordnete elektrische Steckverbinder ist derart gestaltet, dass kein Fluid von dem Innenraum zu dem Außenraum gelangen kann. Hierbei ist das Steckergehäuse an seiner Außenwandung im Allgemeinen mit einem Elastomerdichtring gegen das Getriebegehäuse abgedichtet. In der Regel sind in dem Steckergehäuse des elektrischen Steckverbinders elektrische Steckkontakte angeordnet, welche von dem Außenraum in den Innenraum ragen. Diese Steckkontakte werden gegenüber dem aus Kunststoff gefertigten Steckergehäuse abgedichtet. Dies kann beispielsweise dadurch erfolgen, dass die Steckkontakte besonders geformte Oberflächenprofile wie beispielsweise ein Tannenbaumprofil in dem Bereich besitzen, mit dem die Steckkontakte an das Steckergehäuse verbunden sind. Auch ist bekannt, die Abdichtung mit O-Ringen auszuführen, die an jedem Steckkontakt angebracht sind. Weiterhin sind Abdichtungen durch Vergießen mit beispielsweise Polyurethan, Epoxydharz, Silikonen oder ähnlichen Stoffen bekannt. Elektrische Steckverbinder aus dem Stand der Technik sind aus der WO2009/130156 A1 und der JP H09 186475 A bekannt.

Allerdings hat sich gezeigt, dass nach einigen Temperaturwechseln innerhalb des Automatikgetriebes, wobei die Temperaturschwankungen zwischen -40°C und +150°C betragen können, sich die Haftung oder Pressung zwischen dem Steckkontakt und dem Steckergehäuse lösen kann. Auch neigen Vergussmassen zu Rissbildungen oder sind gegenüber den Automatikgetriebeölen nicht ausreichend beständig. Dies führt zu Undichtigkeiten insofern, als dass nun Fluid von dem Innenraum entlang der Steckkontakte durch das Steckergehäuse in den Außenraum gelangen kann.

### Zusammenfassung der Erfindung

Es kann ein Bedürfnis bestehen, einen elektrischen Steckverbinder für einen Durchbruch in einem Gehäuse bereitzustellen, wobei das Gehäuse einen mit Fluid gefüllten Innenraum von einem Außenraum fluiddicht trennt, bei dem sicher verhindert ist, dass Fluid vom Innenraum entlang seiner Steckkontakte in den Außenraum gelangt.

Das Bedürfnis kann befriedigt werden durch den Gegenstand des unabhängigen Patentanspruchs. Weitere vorteilhafte Ausgestaltungen der Erfindung ergeben sich durch die Gegenstände der abhängigen Patentansprüche. Gemäß einem ersten Ausgestaltungsbeispiel der Erfindung wird ein elektrischer Steckverbinder aus elektrisch nicht-leitfähigem Material mit einem Steckergehäuse mit einer Innenwandung und wenigstens einem Steckkontakt bereitgestellt. Die Innenwandung begrenzt einen ersten Raum. Der Steckkontakt weist ein von einem Gegensteckkontakt kontaktierbares erstes Ende und ein dem ersten Ende gegenüberliegendes zweites Ende auf. Das zweite Ende ist mit einer Leiterplatte mittels Lot verbunden. Das Steckergehäuse ist von dem ersten Ende in Richtung des zweiten Endes über den wenigstens einen Steckkontakt in axialer Richtung in eine vorbestimmte Position verlagert. In der vorbestimmten Position weist der Steckkontakt quer zu der axialen Richtung fehlenden Kraftschluss auf. In der vorbestimmten Position ist die Leiterplatte fest mit dem Steckergehäuse verbunden. In der vorbestimmten Position ragt das erste Ende in den ersten Raum.

Eine Lötstelle des Steckkontakts mit der Leiterplatte und der Ausbildung eines Lotmeniskus ist bei fachgerechter Ausführung fluiddicht insbesondere gegenüber Automatikgetriebeöl. Somit kann kein Fluid durch die Lötstelle hindurch von einer ersten Seite der Leiterplatte zu einer der ersten Seite gegenüberliegenden zweiten Seite der Leiterplatte gelangen. Dementsprechend wird die Leiterplatte fluiddicht ausgestaltet sein, so dass ebenfalls kein Fluid durch die Leiterplatte hindurchgelangen kann. Die feste Verbindung von Steckergehäuse und Leiterplatte kann derart gestaltet sein, dass kein Fluid zwischen das Steckergehäuse und die Leiterplatte gelangen kann, um von dort in einen Außenraum zu gelangen. Hierbei kann beispielsweise ein Dichtelement zwischen der Leiterplatte und einem den Steckverbinder umgebenden Gehäuse, das beispielsweise als ein Automatikgetriebegehäuse ausgebildet sein kann, derart angeordnet werden, dass kein Fluid an dem Dichtelement vorbei zu der festen Verbindung zwischen Leiterplatte und Steckergehäuse gelangen kann. Die feste Verbindung kann beispielsweise durch Kleben hergestellt werden. Die feste Verbindung kann auch fluiddicht ausgeführt sein. Eine fluiddichte Verbindung von Steckergehäuse und Leiterplatte kann beispielsweise ebenfalls durch eine Verklebung oder durch ein Einlegen eines Dichtelements erreicht werden. Natürlich kann auch das Steckergehäuse fluiddicht ausgebildet sein. Die Leiterplatte kann starr oder flexibel ausgebildet sein. Wenn die Leiterplatte flexibel ausgebildet ist, dann wird in der Regel ein Stützelement an einer der von dem Steckergehäuse abgewandten Seite der Leiterplatte mit der flexiblen Leiterplatte fest verbunden sein. Wenn die Leiterplatte starr ausgeführt ist, dann wird die Leiterplatte aus glasfaserverstärktem Harz hergestellt sein, wobei das Harz beispielsweise Epoxyd-, Phenol- oder Polyesterharz sein kann. In der Regel wird die Leiterplatte eine Qualität von FR4 oder höher besitzen. Die Festigkeit des Steckkontakts gegen eine axiale Bewegung, also einer Bewedung in Längserstreckungsrichtung des Steckkontakts, erfolgt durch die stoffschlüssige Verbindung des Steckkontakts mit der Leiterplatte. Wenn also die Leiterplatte nicht vorhanden wäre, wäre der Steckkontakt relativ zu dem Steckergehäuse axial verlagerbar. Da zuerst die Leiterplatte mit den Steckkontakten bestückt sein kann, bevor die Leiterplatte und das Steckergehäuse gefügt werden, können die Steckkontakte beispielsweise in SMT (Surface-Mounting-Technology) an der ersten Seite der Leiterplatte unlösbar verbunden sein, wobei die erste Seite dem Steckergehäuse zugewandt ist. In vorteilhafter Weise kann die Stabilität des Steckkontakts in der Leiterplatte erhöht werden, wenn das zweite Ende des Steckkontakts in einer in der Leiterplatte an der ersten Seite ausgebildeten Ausnehmung, wie beispielsweise eine Sackbohrung, angeordnet ist. In vorteilhafter Weise kann die Stabilität weiter erhöht werden, indem das zweite Ende von der ersten Seite der Leiterplatte durch einen Durchbruch in der Leiterplatte hindurchgeführt ist, wobei das zweite Ende über eine der ersten Seite gegenüberliegende zweite Seite hinausragt. Hierbei kann der Steckkontakt mittels eines Selektivlötprozesses mit der Leiterplatte derart stoffschlüssig verbunden werden, dass sich sowohl an der ersten Seite als auch an der zweiten Seite der Leiterplatte ein Lotmeniskus ausbildet. Durch die stoffschlüssige Lötverbindung kann somit kein Fluid von dem Innenraum entlang des zweiten Endes des Steckkontakts von der zweiten Seite zu der ersten Seite der Leiterplatte gelangen und umgekehrt. Der durch die Leiterplatte durchgesteckte Steckkontakt kann an der ersten Seite oder auch an der zweiten Seite der Leiterplatte gelötet werden. Die Leiterplatte kann auch in einem Reflow-Ofen gelötet sein. Das Steckergehäuse selbst muss nicht aus einem Kunststoff gefertigt sein, der gegenüber dem Reflow-Lötverfahren beständig ist, da die Leiterplatte erst nach dem Reflow-Löten mit dem Steckergehäuse fluidicht unlösbar verbunden wird.

Gemäß einem weiteren Ausgestaltungsbeispiel der Erfindung weist der Steckkontakt zu dem Steckergehäuse fehlende Fluiddichtigkeit auf.

Damit kann auf das Einbringen von Dichtmassen wie beispielsweise Vergussmassen oder Dichtmitteln wie beispielsweise O-Ringe zwischen Steckkontakt und Steckergehäuse verzichtet sein. Es kann sogar der Steckkontakt von dem Steckergehäuse beabstandet sein.

Gemäß einem weiteren Ausgestaltungsbeispiel der Erfindung ist ein Brückenelement an die Innenwandung des elektrischen Steckverbinders fest verbunden. Das Brückenelement weist wenigstens eine sich in eine Längserstreckungsrichtung des Steckkontakts erstreckende Öffnung auf. Der wenigstens eine Steckkontakt ist durch die wenigstens eine Öffnung geführt. Der wenigstens eine Steckkontakt ist durch das Brückenelement ausschließlich in radialer Richtung gestützt.

Hierbei kann der Steckkontakt lose in dem Brückenelement sein, so dass ein Fluid von dem Außenraum entlang des ersten Endes durch die Öffnung entlang des Steckkontakts an die Leiterplatte gelangen kann. Jedoch verhindert die Leiterplatte mit dem eingelöteten Steckkontakt ein weiteres Ausbreiten dieses Fluids. Damit der dem Steckergehäuse zugewandte Lotmeniskus an der ersten Seite der Leiterplatte in vorteilhafter Weise nicht mit dem Brückenelement kollidiert, kann der erste Raum durch das Brückenelement in einen zweiten Raum und einen dritten Raum gegliedert sein, wobei in dem zweiten Raum das erste Ende des Steckkontakts angeordnet ist. Der dritte Raum kann derart gestaltet sein, dass der in den dritten Raum ragende Lotmeniskus weder durch das Steckergehäuse noch durch das von der Leiterplatte beabstandete Brückenelement behindert ist. Das Brückenelement stützt den wenigstens einen Steckkontakt gegen ein seitliches Ausweichen oder Verbiegen aufgrund eines Aufsteckens einer elektrischen Gegensteckverbinders mit einem mit Gegensteckkontakten bestückten Gegensteckergehäuse auf den elektrischen Steckverbinder. Wenn der Steckkontakt nicht mit der Leiterplatte verbunden wäre, könnte er in axialer Richtung, also in Längserstreckungsrichtung des Steckkontakts, bewegt werden. Im Gegensatz hierzu sind die Steckkontakte von elektrischen Steckverbindern nach dem Stand der Technik, welche möglicherweise zum Einlöten in Leiterplatten eingerichtet sind, unlösbar mit dem zugehörigen Steckergehäuse verbunden. Die radiale Richtung erstreckt sich quer zu der axialen Richtung.

Gemäß einem weiteren Ausgestaltungsbeispiel der Erfindung weist der Steckkontakt des elektrischen Steckverbinders eine Verdickung auf. Die Verdickung stützt sich an dem Brückenelement derart ab, dass eine translatorische Bewegung des Steckkontakts in Richtung des ersten Ende verhindert ist.

Durch die Verdickung kann erreicht werden, dass bei einem Abziehen des elektrischen Gegensteckverbinders von dem elektrischen Steckverbinder die hierbei auftretenden Kräfte von der Leiterplatte ferngehalten werden können. In der Regel wird sich die Verdickung an dem Steckkontakt in dem dritten Raum des Steckergehäuses erstrecken.

Gemäß einem weiteren Ausgestaltungsbeispiel der Erfindung ist eine elektrische Leitung an die Leiterplatte für eine elektrisch leitfähige Verbindung mit dem wenigstens einen Steckkontakt unlösbar verbunden.

Die elektrische Leitung kann hierbei beispielsweise an einem SMD(Surface-Mounted Device)-Wire-Clip verbunden sein. Auch kann die elektrische Leitung als ein Streifen ausgebildet sein, welcher aus einer flexiblen Leiterplatte gefertigt ist. Die elektrische Leitung kann an die starre Leiterplatte elektrisch leitend verbunden werden, beispielsweise durch Löten oder Schweißen. Auch kann, wenn der Steckkontakt an einer flexiblen Leiterplatte befestigt ist, die flexible Leiterplatte verlängert sein, so dass auf eine zusätzliche elektrische Leitung verzichtet werden kann. Auch kann die starre Leiterplatte eine zwischen der ersten Seite und der zweiten Seite in Längserstreckungsrichtung der Leiterplatte eine Leiterbahn aufweisen, die die elektrische Leitung mit dem Steckkontakt elektrisch leitfähig verbindet. Damit kann beispielsweise die Leitung, respektive deren Kontaktelemente wie beispielsweise der SMD-wire-clip in Randnähe der Leiterplatte angeordnet sein. In der Regel wird die Leitung an der dem Steckergehäuse gegenüberliegenden zweiten Seite der Leiterplatte elektrisch leitfähig verbunden sein.

Gemäß einem weiteren Ausgestaltungsbeispiel der Erfindung ist eine elektrische Leitung an dem wenigstens einen Steckkontakt elektrisch leitfähig lösbar verbunden.

Hierbei wird die Leitung direkt an dem Steckkontakt kontaktiert. Dies kann beispielsweise durch Schweißen oder Löten erfolgen. Auch kann hierbei das aus der zweiten Seite der Leiterplatte herausragende zweite Ende verlängert sein, so dass bei einem Verbinden der Leitung an den Steckkontakt die bei dem Schweiß- oder Lötvorgang auftretende Wärme die Lötstelle des Steckkontakts mit der Leiterplatte nicht schädigen kann. Natürlich kann auf eine derartige Verlängerung auch verzichtet werden, wenn die Leitung beispielsweise durch Crimpen, also ohne Wärmeeinwirkung, an dem Steckkontakt elektrisch leitfähig verbunden wird.

Gemäß einem weiteren Ausgestaltungsbeispiel der Erfindung weist das Steckergehäuse eine der Innenwandung gegenüberliegende Außenwandung auf. An der Außenwandung ist ein Aufnahmeelement zur Aufnahme eines umlaufenden ersten Dichtelements ausgebildet.

Meist wird der elektrische Steckverbinder in einem Durchbruch in einem fluiddichten, den Innenraum gegenüber einem Außenraum fluiddicht trennendes Gehäuse angeordnet sein. Das Dichtelement kann Bestandteil des Steckergehäuses sein und hierbei das Steckergehäuse gegenüber dem Gehäuse, beispielsweise dem Automatikgetriebegehäuse, abdichten, so dass kein Fluid aus dem Innenraum zwischen Steckergehäuse und dem Gehäuse von dem Innenraum in den Außenraum gelangen kann. Das Aufnahmeelement kann beispielsweise zur Aufnahme einer Flachdichtung oder einer Runddichtung ausgebildet sein.

Gemäß einem weiteren Ausgestaltungsbeispiel der Erfindung ist das Aufnahmeelement als eine U-förmige Nut mit einem ersten Schenkel, einem dem ersten Schenkel gegenüberliegenden zweiten Schenkel und einem die beiden Schenkel unlösbar miteinander verbindenden Verbindungsstück ausgebildet. Der erste Schenkel und das Verbindungsstück sind durch die Außenwandung gebildet. Der zweite Schenkel ist durch die Leiterplatte gebildet.

Hierdurch kann das Dichtelement beispielsweise in der Ausbildung eines O-Rings an das Steckergehäuse angeordnet werden, so dass das Dichtelement an dem ersten Schenkel und/oder an dem Verbindungsstück anliegt. Anschließend kann das Dichtelement mittels der Leiterplatte, die unlösbar an das Steckergehäuse verbunden wird, wobei der zweite Schenkel an der Leiterplatte ausgebildet ist, fixiert werden. Damit entfällt ein Überstülpen des Dichtelements über einen der beiden Schenkel, um zwischen den beiden Schenkeln angeordnet zu werden. Insbesondere ein derartiges Überstülpen des Dichtelements über einen der Schenkel kann zu einer irreversiblen Dehnung des Dichtelements und damit zu einer Schädigung führen.

Gemäß einem weiteren Ausgestaltungsbeispiel der Erfindung ist innerhalb des ersten Raums die Leiterplatte angeordnet, wobei die Leiterplatte fluiddicht mit der Innenwandung verbunden ist.

In dieser Ausgestaltung kann die Leiterplatte in dem Steckergehäuse eingebettet sein. Auch können an der Innenwandung Haltelemente vorgesehen sein, die ein Lösen der Leiterplatte aus dem Innenraum in translatorischer Richtung entlang der Längserstreckungsrichtung der Steckkontakte verhindern. Wenn das Steckergehäuse aus Kunststoff gefertigt ist, können diese Halteelemente beispielsweise durch Warmverstemmung erzeugt werden. Auch können die Halteelemente durch Kleben oder Einschweißen eines Kunststoffrings erfolgen. Auch kann an der Innenwandung beispielsweise eine umlaufende Nut eingearbeitet sein, in die ein Sprengring eingelegt werden kann, der die Leiterplatte im Innenraum fixiert.

Gemäß einem weiteren Ausgestaltungsbeispiel der Erfindung ist ein umlaufendes zweites Dichtelement zwischen der Leiterplatte und einem Brückenelement angeordnet.

Bedingt durch das Brückenelement kann die Leiterplatte in dem dritten raum angeordnet sein. Das Dichtelement kann verhindern, dass ein zwischen der Leiterplatte und der Innenwandung des dritten Raums möglicherweise durchsickerndes Fluid nicht zu dem durch das Bodenelement hindurchgeführten Bereich des Steckkontakts gelangen kann.

Gemäß einem weiteren Ausgestaltungsbeispiel der Erfindung ist das erste und/oder das zweite Dichtelement ein O-Ring.

Gemäß einem weiteren Ausgestaltungsbeispiel der Erfindung wird eine Anordnung mit einem Gehäuse und einem wie im Vorhergehenden beschriebenen elektrischen Steckverbinder bereitgestellt. Das Gehäuse trennt einen Innenraum von einem das Gehäuse umgebenden Außenraum. Das Gehäuse weist einen Durchbruch auf. Der elektrische Steckverbinder ist in dem Durchbruch angeordnet. Das Gehäuse und der Steckverbinder sind durch das in dem Aufnahmeelement der Außenwandung umlaufende erste Dichtelement miteinander fluiddicht verbunden.

Somit kann kein in dem Innenraum des Gehäuses vorhandenes Fluid an der Außenwandung des elektrischen Steckverbinders bzw. entlang des Durchbruchs zu dem Außenraum gelangen.

Gemäß einem weiteren Ausgestaltungsbeispiel der Erfindung weist das Gehäuse einen Bund auf. In dem Innenraum des Gehäuses ist eine technische Feder angeordnet. Die technische Feder und das Steckergehäuse des elektrischen Steckverbinders wirken derart zusammen, dass ein erster Schenkel des Aufnahmelements an den Bund gedrückt wird.

Die technische Feder kann beispielsweise eine Blattfeder, eine Schenkelfeder oder auch eine Druckfeder sein. Durch die technische Feder ist gewährleistet, dass das Steckergehäuse immer mit nahezu gleichbleibender Kraft an den Bund angedrückt wird. Damit können Relativbewegungen der Komponenten aufgrund von Temperatureinwirkungen egalisiert werden.

Gemäß einem weiteren Ausgestaltungsbeispiel der Erfindung ist die technische Feder als eine Blattfeder mit einem ersten Ende und einem dem ersten Ende gegenüberliegenden zweiten Ende ausgebildet. Das erste Ende ist an das Gehäuse unlösbar verbunden. Das zweite Ende übt eine Kraft an dem elektrischen Steckverbinder aus.

Gemäß einem weiteren Ausgestaltungsbeispiel der Erfindung ist das Gehäuse ein Automatikgetriebegehäuse für ein Kraftfahrzeug.

Somit handelt es sich bei dem in dem Innenraum vorhandenen Fluid in der Regel um Automatikgetriebeöl.

Gemäß einem weiteren Ausgestaltungsbeispiel der Erfindung wird ein Automatikgetriebe für ein Kraftfahrzeug mit einem im Vorhergehenden beschriebenen elektrischen Steckverbinder bereitgestellt.

Gemäß einem weiteren Ausgestaltungsbeispiel der Erfindung wird ein Verfahren zum Herstellen eines elektrischen Steckverbinders aus elektrisch nicht-leitfähigem Material mit einem Steckergehäuse mit einer Innenwandung und wenigstens einem Steckkontakt bereitgestellt. Die Innenwandung begrenzt einen ersten Raum. Der Steckkontakt weist ein von einem Gegensteckkontakt kontaktierbares erstes Ende und ein dem ersten Ende gegenüberliegendes zweites Ende auf. Das Verfahren weist folgende Schritte auf: Verbinden des zweiten Endes mit einer Leiterplatte mittels Lot; Verlagern des Steckergehäuses von dem ersten Ende in Richtung des zweiten Endes über den wenigstens einen Steckkontakt in axialer Richtung in eine vorbestimmte Position; Verbinden der Leiterplatte in der vorbestimmten Position mit dem Steckergehäuse in fluiddichter Weise, wobei in der vorbestimmten Position der Steckkontakt quer zu der axialen Richtung fehlender Kraftschluss aufweist, wobei in der vorbestimmten Position das erste Ende in den ersten Raum ragt.

Es wird angemerkt, dass Gedanken zu der Erfindung hierin im Zusammenhang mit einem elektrischen Steckverbinder, einer Anordnung mit einem Gehäuse und einem elektrischen Steckverbinder, einem Automatikgetriebe sowie einem Verfahren zum Herstellen eines elektrischen Steckverbinders beschrieben sind. Einem Fachmann ist hierbei klar, dass die einzelnen beschriebenen Merkmale auf verschiedene Weise miteinander kombiniert werden können, um so auch zu anderen Ausgestaltungen der Erfindung zu gelangen.

### Kurze Beschreibung der Zeichnungen

Ausführungsformen der Erfindung werden nachfolgend mit Bezug auf die beigefügten Figuren beschrieben. Die Figuren sind lediglich schematisch und nicht maßstabsgetreu.
- Figur 1: zeigt eine Anordnung mit einem Gehäuse und einem elektrischen Steckverbinder nach dem Stand der Technik, der in einem Durchbruch in dem Gehäuse angeordnet ist, in einem Längsschnitt;
- Figur 2: zeigt eine erste Variante eines elektrischen Steckverbinder in einem Längsschnitt;
- Figur 3: zeigt die aus Figur 2 bekannte Anordnung mit einem elektrischen Steckverbinder mit einer elektrischen Leitung, der in dem Durchbruch des Gehäuses montiert ist, im Längsschnitt;
- Figur 4: zeigt die aus Figur 3 bekannte Anordnung mit einem elektrischen Steckverbinder, bei dem seine Steckkontakte in Ausnehmungen einer starren Leiterplatte angeordnet sind, im Längsschnitt;
- Figur 5: zeigt die aus Figur 3 bekannte Anordnung mit einem elektrischen Steckverbinder, bei dem die elektrische Leitung durch eine flexible Leiterplatte ersetzt ist, im Längsschnitt;
- Figur 6: zeigt die aus Figur 3 bekannte Anordnung mit einem elektrischen Steckverbinder, bei dem die starre Leiterplatte durch eine flexible Leiterplatte ersetzt ist, im Längsschnitt;
- Figur 7: zeigt die aus Figur 3 bekannte Anordnung mit einem elektrischen Steckverbinder, bei dem die Steckkontakte durch eine starre Leiterplatte hindurchragen, im Längsschnitt;
- Figur 8: zeigt die aus Figur 7 bekannte Anordnung mit einem elektrischen Steckverbinder, bei dem die Leiterplatte zur Aufnahme von weiteren elektrischen Bauelementen vergrößert ist, im Längsschnitt;
- Figur 9: zeigt die aus Figur 1 bekannte Anordnung mit einer zweiten Variante eines elektrischen Steckverbinders, bei dem die starre Leiterplatte in einem durch eine Innenwandung begrenzten Raum angeordnet ist, im Längsschnitt;
- Figur 10: zeigt die aus Figur 3 bekannte Anordnung, bei der eine Dichtelementaufnahme derart gestaltet wurde, dass eine Verbindung zwischen einem Steckergehäuse und der Leiterplatte nicht fluiddicht ausgestaltet ist; und
- Figur 11: zeigt ein Verfahren zum Herstellen des elektrischen Steckverbinders in einem Blockdiagramm.

### Detaillierte Beschreibung beispielhafter Ausführungsformen

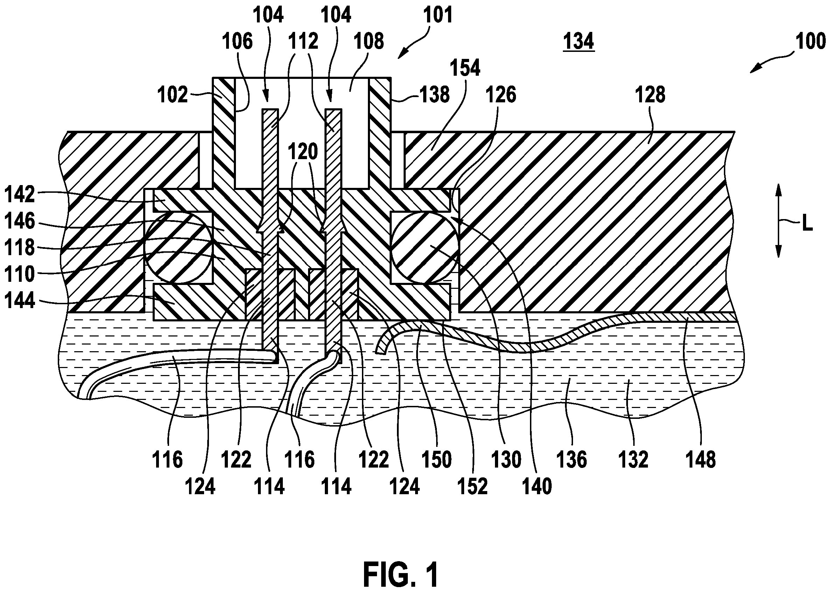

Figur 1 zeigt eine Anordnung 100 mit einem Gehäuse 128 und mit einem elektrischen Steckverbinder 101 nach dem Stand der Technik. Der elektrische Steckverbinder 101 ist aus elektrisch nicht leitfähigem Material gefertigt und besitzt ein Steckergehäuse 102 und wenigstens einen Steckkontakt 104. Das Steckergehäuse 102 besitzt eine zylindrische Innenwandung 106 und ein Brückenelement 110, wobei ein erster Raum 108 durch die zylindrische Innenwandung 106 und das Brückenelement 110 begrenzt ist. Der Steckkontakt 104 besitzt ein von einem Gegensteckkontakt kontaktierbares erstes Ende 112 und ein dem ersten Ende 112 gegenüberliegendes zweites Ende 114. Das zweite Ende 114 ist mit einer Leitung 116 elektrisch leitfähig und unlösbar verbunden. Das erste Ende 112 ragt in den ersten Raum 108. Zwischen dem ersten Ende 112 und dem zweiten Ende 114 befindet sich ein erstes Mittelteil 118, welches mit dem Brückenelement 110 formschlüssig verbunden ist. Hierzu ist das erste Mittelteil 118 als ein Tannenbaumprofil 120 ausgebildet. Anschließend an das erste Mittelteil 118 erstreckt sich in Richtung des zweiten Endes 114 ein zweites Mittelteil 112, welches mittels einer Vergussmasse 124 gegenüber dem Steckergehäuse 102 abgedichtet ist. Der elektrische Steckverbinder 101 ist in einem Durchbruch 126 des Gehäuses 128 angeordnet. Das Gehäuse 128 trennt einen Innenraum 132 fluiddicht von einem Außenraum 134, wobei sich in dem Innenraum 132 Fluid 136, welches beispielsweise Automatikgetriebeöl sein kann, befindet. Der Innenwandung 106 des Steckergehäuses 102 gegenüberliegend ist eine Außenwandung 138 ausgebildet. Die Außenwandung 138 besitzt eine U-förmige Aufnahme 140 mit einem ersten Schenkel 142, einem zweiten Schenkel 144 sowie einem den ersten 142 und den zweiten Schenkel 144 fest verbindenden Verbindungsstück 146. Zwischen dem ersten Schenkel 142 und dem zweiten Schenkel 144 ist ein als O-Ring ausgebildetes erstes Dichtelement 130 angeordnet. Durch das erste Dichtelement 130 ist in bewährter Weise vermieden, dass das Fluid 136 aus dem Innenraum 132 an der Außenwandung 138 des Steckergehäuses 102 und/oder an dem Durchbruch 126 vorbei zu dem Außenraum 134 gelangen kann. Ferner stützt sich eine technische Feder 148, die als Blattfeder ausgebildet ist, an dem Gehäuse 128 ab. Die Blattfeder besitzt ein freies Ende 150, welches gegen eine Unterseite 152 des Steckergehäuses 102 drückt und hierbei das erste Ende 112 gegen einen in dem Gehäuse 128 ausgebildeten Bund 154 drückt.

Es hat sich gezeigt, dass bei einer derartigen Ausgestaltung des elektrischen Steckverbinders 101 aufgrund von Temperaturschwankungen von -40°C bis +150°C die Vergussmasse 124 verspröden kann. Weiterhin hat sich gezeigt, dass die anfangs fluiddichte Verbindung des ersten Mittelteils 118 zu dem Steckergehäuse 102, respektive dem Brückenelement 110 sich löst, so dass das in dem Innenraum 132 vorhandene Fluid 136 entlang des Steckkontakts 104 in einer Längserstreckungsrichtung L des Steckkontakts 104 von dem zweiten Ende 114 über das zweite Mittelteil 112 und weiter über das erste Mittelteil 118 in den ersten Raum 108 gelangt und damit in den Außenraum 134.

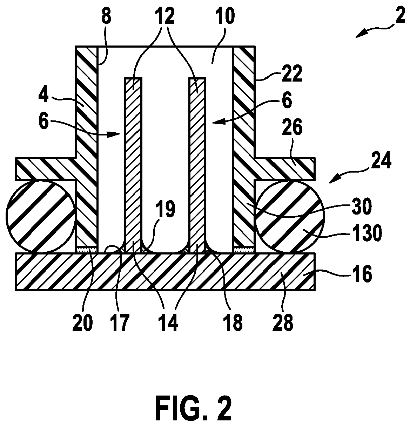

Figur 2 zeigt einen elektrischen Steckverbinder 2 aus elektrisch nicht leitfähigem Material mit einem Steckergehäuse 4 und zwei Steckkontakten 6. Das Steckergehäuse 4 besitzt eine zylindrische Innenwandung 8, die einen ersten Raum 10 begrenzt. Jeder Steckkontakt 6 besitzt ein von einem Gegensteckkontakt kontaktierbares erstes Ende 12 und ein dem ersten Ende 12 gegenüberliegendes zweites Ende 14. Das zweite Ende 14 ist stumpf an eine erste Seite 17 einer starren Leiterplatte 16 aufgesetzt und mit der Leiterplatte 16 stoffschlüssig mittels Lot 18 verbunden. Die erste Seite 17 ist dem Steckergehäuse 4 zugewandt. Die stoffschlüssige Verbindung des Steckkontakts 6 mit der Leiterplatte 16 erfolgt unter Ausbildung eines Lotmeniskus 19. Das Steckergehäuse 4 ist mittels einer Klebung 20 mit der ersten Seite 17 der Leiterplatte 16 fluiddicht unlösbar verbunden. Der Innenwandung 8 gegenüberliegend besitzt das Steckergehäuse 4 eine Außenwandung 22, an der in Verbindung mit der Leiterplatte 16 ein U-förmiges Aufnahmeelement 24 ausgebildet ist. Das Aufnahmeelement 24 ist durch einen ersten Schenkel 26, einen dem ersten Schenkel 26 gegenüberliegenden zweiten Schenkel 28 und ein den ersten 26 und den zweiten Schenkel 28 fest verbindendes Mittelstück 30 gebildet. Hierbei ist der erste Schenkel 26 und das Mittelstück 30 in der Außenwandung 22 des Steckergehäuses 4 ausgebildet, während der zweite Schenkel 28 in der Leiterplatte 16 ausgebildet ist. In dem Aufnahmeelement 24 ist das bereits aus der Figur 1 bekannte erste Dichtelement 130 angeordnet. In der hier dargestellten Ausführungsform kann das erste Dichtelement 130 an das Steckergehäuse 4 montiert werden, bevor die Leiterplatte 16 mit dem Steckergehäuse 4 fest verbunden wird. Damit wird einer Dehnung des ersten Dichtelements 130 vorgebeugt, das ansonsten über den ersten 26 oder den zweiten Schenkel 28 gestülpt werden müsste, damit es in seinem Aufnahmeelement 24 angeordnet werden kann.

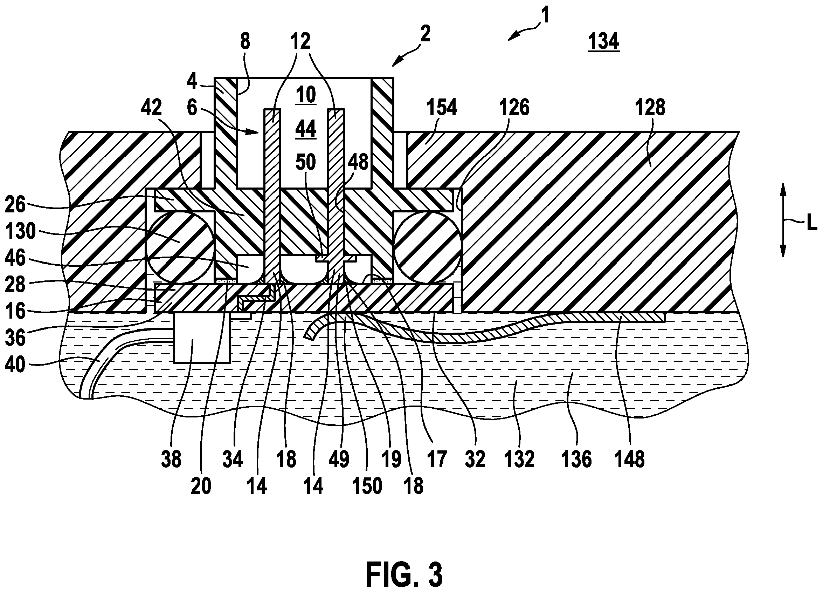

Figur 3 zeigt eine Anordnung 1 mit dem Gehäuse 128 und mit dem aus Figur 2 bekannten elektrischen Steckverbinder 2, wobei der elektrische Steckverbinder 2 in dem aus Figur 1 bekannten Durchbruch 126 des Gehäuses 128 angeordnet ist. Der ersten Seite 17 der starren Leiterplatte 16 gegenüberliegend erstreckt sich eine zweite Seite 32. Zwischen der ersten Seite 17 und der zweiten Seite 32 erstreckt sich im Wesentlichen quer zu der Längserstreckungsrichtung L des Steckkontakts 6 eine Leiterbahn 34. Die Leiterbahn 34 verbindet elektrisch leitfähig den Steckkontakt 6 mit einem an einem Randbereich 36 der Leiterplatte 16 fest verbundenen SMD(Surface-Mounting Device)-wire-clip 38 elektrisch leitfähig. An dem SMD-wire-clip 38 ist eine elektrische Leitung 40 elektrisch leitfähig unlösbar verbunden. An der Innenwandung 8 des Steckergehäuses 4 ist unlösbar ein sich im Wesentlichen quer zu der Längserstreckungsrichtung L des Steckkontakts 6 erstreckendes Brückenelement 42 unlösbar verbunden. Das Brückenelement 42 gliedert in dem hier vorliegenden Ausführungsbeispiel den ersten Raum 10 in einen zweiten Raum 44 und einen dritten Raum 46. Hierbei erstreckt sich in den zweiten Raum 44 das erste Ende 12 des Steckkontakts 6. Der dritte Raum 46 ist derart gestaltet, dass weder die Innenwandung 8 noch das Brückenelement 42 die Lotmenisken 19 kontaktieren. Das Brückenelement 42 besitzt eine Öffnung 48, durch die der Steckkontakt 6 hindurchgeführt ist. Das Brückenelement 42 verhindert, dass, wenn die Steckkontakte 6 mit hier nicht dargestellten Gegensteckkontakten kontaktiert werden, die Steckkontakte 6 nicht seitlich, also quer zu der Längserstreckungsrichtung L der Steckkontakte 6 ausweichen oder verbiegen können. Somit werden die Steckkontakte 6 in radialer Richtung durch das Brückenelement 42 gestützt, wohingegen die Steckkontakte 6 in translatorischer Richtung, also entlang ihrer Längserstreckungsrichtung L, lose sein können. Wie an dem rechts dargestellten Steckkontakt 6 ersichtlich ist, kann an einem sich in dem dritten Raum 46 erstreckenden Teilbereich 49 des Steckkontakts 6 eine Verdickung 50 ausgebildet sein, welche sich an dem Brückenelement 42 abstützt. Damit wird vermieden, dass eine beim Abziehen des Gegensteckkontakts von dem Steckkontakt 6 auf den Steckkontakt 6 aufgebrachte Kraft durch das Lot 18, respektive den Lotmeniskus 19, aufgenommen werden muss. Weiterhin ist ersichtlich, da das Steckergehäuse 4 mittels einer Klebung 20 mit der Leiterplatte 16 fluiddicht verbunden ist, kein Fluid 136 aus dem Innenraum 132 zwischen der Leiterplatte 16 und dem Steckergehäuse 4 hin zu dem Steckkontakt 6 gelangen kann. Eine Fixierung des elektrischen Steckverbinders 2 in dem Durchbruch 126 erfolgt dadurch, dass der erste Schenkel 26 gegen den Bund 154 gedrückt wird. Hierbei übt das freie Ende 150 der als Blattfeder abgebildeten technischen Feder 148 eine Kraft gegen die zweite Seite 32 der starren Leiterplatte 16 aus.

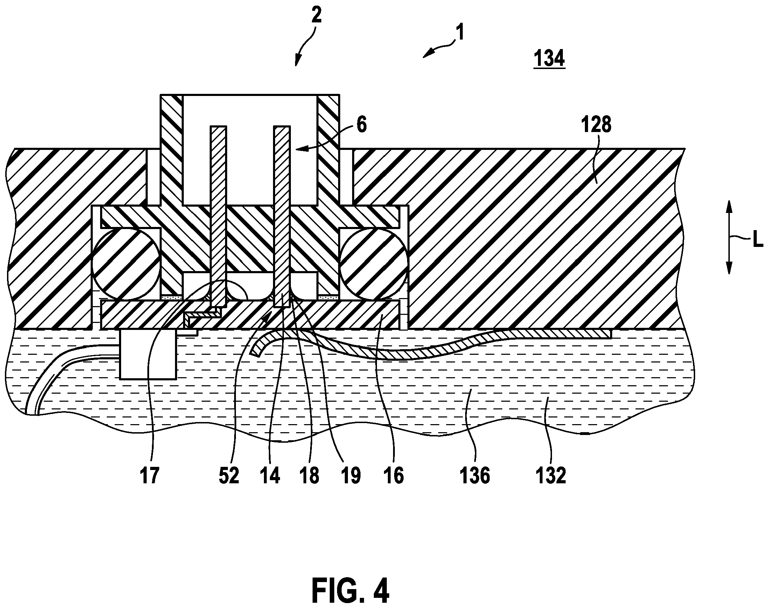

Figur 4 unterscheidet sich von der aus der Figur 3 bekannten Darstellung der Anordnung 1 dadurch, dass in der Leiterplatte 16 an der ersten Seite 17 eine Ausnehmung 52 in Form eines Sackloches ausgebildet ist, in die das zweite Ende 14 des Steckkontakts 6 des elektrische Steckverbinders 2 hineinragt. Hierdurch ist der Steckkontakt 6 mit der Leiterplatte 16 stabiler verbunden, als dies in Figur 3 der Fall ist.

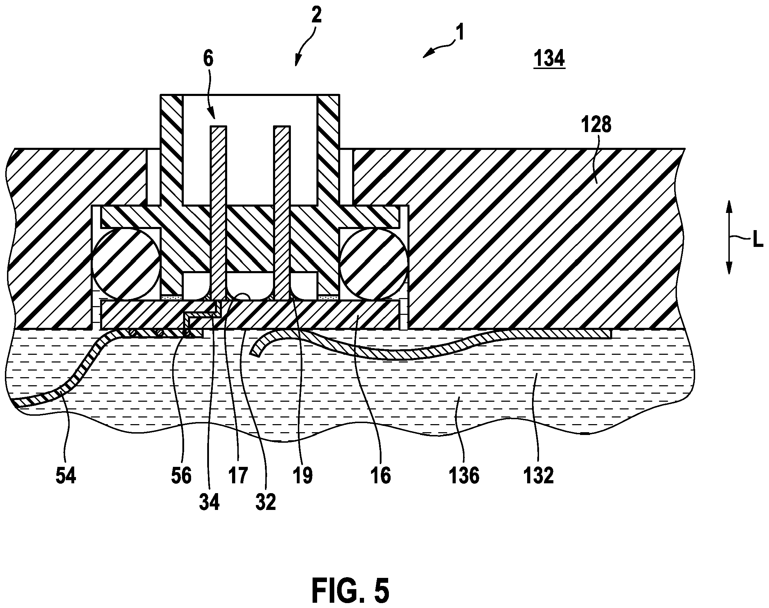

Figur 5 zeigt die aus der Figur 3 bekannte Anordnung 1. Der hier dargestellte elektrische Steckverbinder 2 unterscheidet sich von dem in Figur 3 dargestellten dadurch, dass ist der in Figur 3 dargestellte SMD-wire-clip 38 mit der zugehörigen Leitung 40 durch einen flexiblen Leiterplattenstreifen 54 mit einer innenliegenden Leiterbahn 56 ersetzt ist. Hierbei ist die innenliegende Leiterbahn 56 fest mit der Leiterbahn 34 und damit mit dem Steckkontakt 6 elektrisch leitfähig verbunden. In dem hier dargestellten Ausführungsbeispiel ist dies durch Schweißen erfolgt.

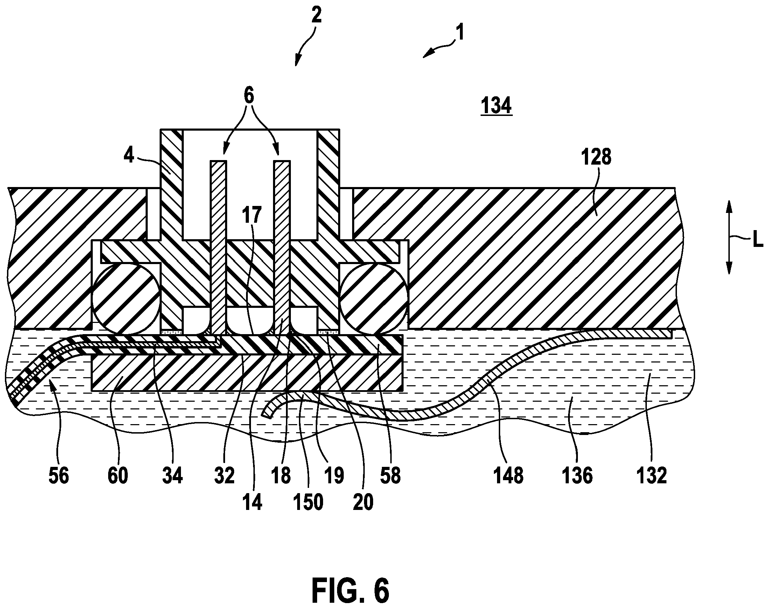

Figur 6 zeigt die aus Figur 3 bekannte Anordnung 1, wobei in der hier gewählten Darstellung die starre Leiterplatte 16 durch eine flexible Leiterplatte 58 ersetzt wurde. Hierbei ist die in der flexiblen Leiterplatte 58 innenliegende Leiterbahn 56 mit dem korrespondierenden Steckkontakt 6 elektrisch leitfähig unlösbar verbunden. Zur Stabilisierung der flexiblen Leiterplatte 58 im Bereich des Steckergehäuses 4 ist die zweiten Seite 32, welche dem Steckergehäuse 4 gegenüberliegend angeordnet ist, unlösbar mit einem Stützelement 60 verbunden. Hierbei drückt das freie Ende 150 der technischen Feder 148 gegen das Stützelement 60.

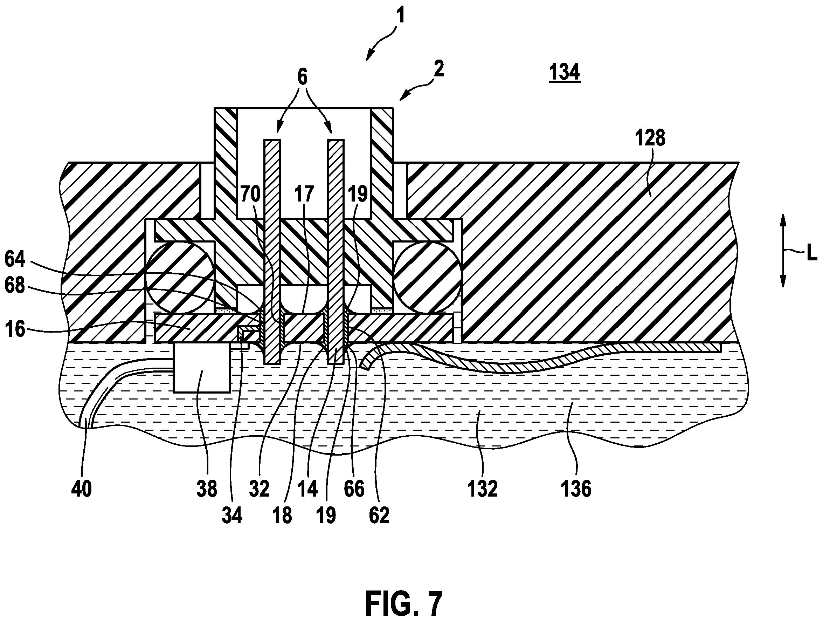

Figur 7 zeigt die aus Figur 3 bekannte Anordnung 1, wobei im Gegensatz zu der Darstellung in Figur 3 die Leiterplatte 16 des elektrischen Steckverbinders 2 einen sich von der ersten Seite 17 zu der zweiten Seite 32 entlang der Längserstreckungsrichtung L des Steckkontakts 6 erstreckenden Durchbruch 62 besitzt. Durch den Durchbruch 62 ist das zweite Ende 14 des Steckkontakts 6 durchgeführt, so dass der Steckkontakt 6 an der zweiten Seite 32 der Leiterplatte 16 in den Innenraum 132 hineinsteht. Der Durchbruch 62 ist an der ersten Seite 17 von einem ersten Lötauge 64 und an der zweiten Seite 32 von einem zweiten Lötauge 66 umringt. Hierbei sind die beiden Lötaugen 64, 66 unlösbar mit der Leiterplatte 16 verbunden. Weiterhin sind das erste 64 und das zweite Lötauge 66 mittels einer Durchkontaktierung 68 miteinander elektrisch leitfähig verbunden. Die Durchkontaktierung 68 bildet eine Innenwandung 70 aus, die den Durchbruch 62 darstellt. Durch das stoffschlüssige Verbinden des zweiten Endes 14 mit der Leiterplatte 16 mittels des Lots 18 bilden sich sowohl an der ersten 17 als auch an der zweiten Seite 32 je ein Lotmeniskus 19 aus. Hierbei kann der Lötvorgang sowohl an der ersten 17 als auch an der zweiten Seite 32 durchgeführt worden sein. Durch die Kapillarwirkung ist auch das erste Ende 14 des Steckkontakts 6 mit der Durchkontaktierung 68 stoffschlüssig verbunden. Da das Lot 20 gegenüber dem Fluid 136 fluiddicht ist, kann kein Fluid 136 entlang des Steckkontakts 6 von der zweiten Seite 32 der Leiterplatte 16 durch den Durchbruch 62 hin zur ersten Seite 17 entlang des Steckkontakts 6 gelangen.

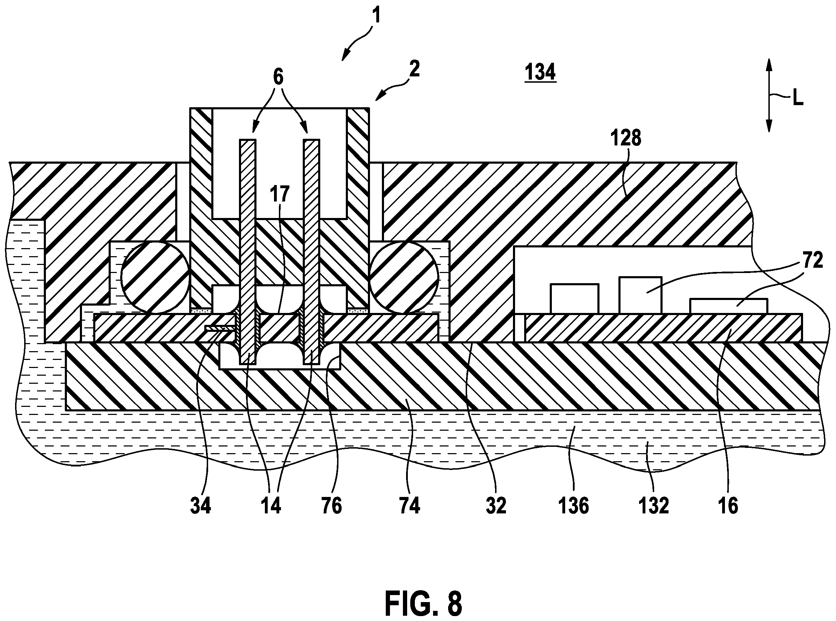

Figur 8 zeigt die aus Figur 7 bekannte Anordnung 1, bei der die Leiterplatte 16 gegenüber der in Figur 7 gewählten Darstellung vergrößert wurde, um weitere elektrische Bauelemente 72 mit dem Steckkontakt 6 elektrisch leitfähig zu verbinden. Hierbei ist die Leiterplatte 16 an ihrer zweiten Seite 32 an eine Trägerplatte 74 unlösbar verbunden. Weiterhin besitzt die Trägerplatte 74 eine Ausnehmung 76, in die die über die zweite Seite 32 hinausragenden zweiten Enden 14 hineinragen, ohne jedoch die Trägerplatte 74 zu berühren. Die elektrisch leitfähige Verbindung zwischen den weiteren elektrischen Bauelementen 72, welche auch als Steuerungsmodul ausgestaltet sein können, und dem Steckkontakt 6 erfolgt durch die Leiterbahn 34. Dementsprechend ist auf den in Figur 7 dargestellten SMD-wire-clip 38 mit dem zugehörigen Kabel 40 verzichtet.

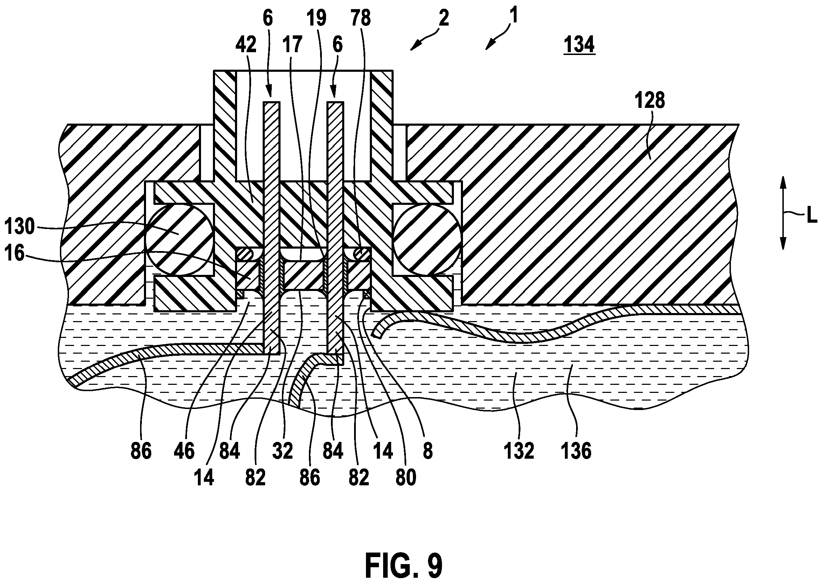

Figur 9 zeigt die aus Figur 3 bekannte Anordnung, bei der die starre Leiterplatte 16 innerhalb des dritten Raums 46 des elektrischen Steckverbinders 2 angeordnet ist. Damit kein Fluid 136 aus dem Innenraum 132 zwischen der Leiterplatte 16 und der Innenwandung 8 hin zu dem ersten Ende 12 des Steckkontakts 6 gelangen kann, ist zwischen der ersten Seite 17 der Leiterplatte 16 und dem Brückenelement 42 ein zweites Dichtelement 78 angeordnet. Damit die Leiterplatte 16 an dem Dichtelement 78 anliegt, ist die Leiterplatte 16 an der zweiten Seite 32 mittels eines mit der Innenwandung 8 verklebten Kunststoff rings 80 fixiert. Weiterhin ist der Steckkontakt 6 mittels einer Verlängerung 82 in den Innenraum 132 hinein verlängert. Hierbei besitzt die Verlängerung 82 ein Kopfelement 84, wobei das Kopfelement 84 mit einer elektrischen Leitung 86 durch einen Schweißprozess elektrisch letfähig unlösbar verbunden ist. Die Verlängerung 82 bewirkt, dass die während des Schweißprozesses entstehende Wärme nicht die stoffschlüssige Verbindung des zweiten Endes 14 mit der Leiterplatte 16 schädigen kann.

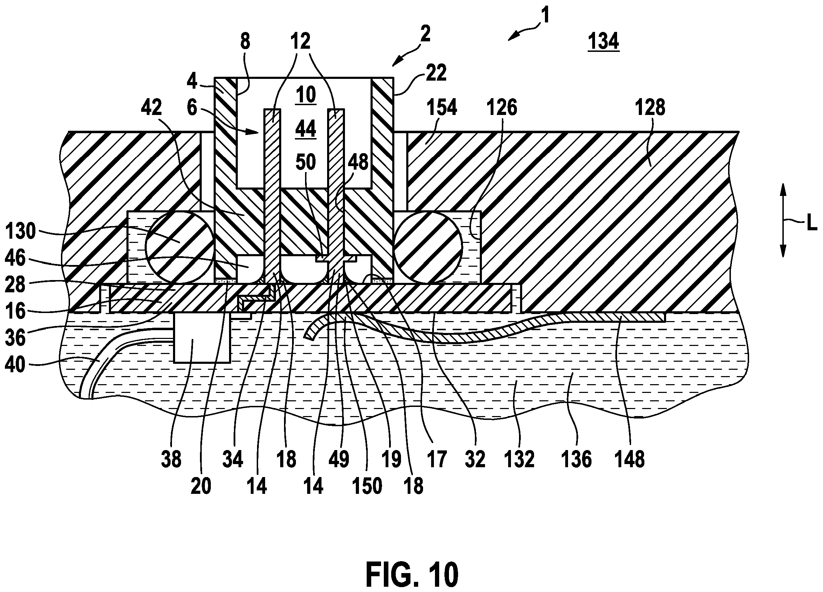

Figur 10 zeigt die aus Figur 3 bekannte Darstellung. Im Gegensatz zu der Darstellung in Figur 3 ist bei der Ausformung der Außenwandung 22 des Steckergehäuses 4 auf den ersten Schenkel 26 verzichtet. Damit liegt das als O-Ring ausgebildete Dichtelement 130 an dem an der Leiterplatte 16 ausgebildeten zweiten Schenkel 28 und an dem Bund 154 an. Somit kann kein Fluid 136 aus dem Innenraum 132 an dem Dichtelement 130 vorbei zu der Klebung 20 gelangen. Entsprechend ist dann die Klebung 20 in dem hier dargestellten Ausführungsbeispiel lediglich fest, nicht jedoch fluiddicht ausgebildet.

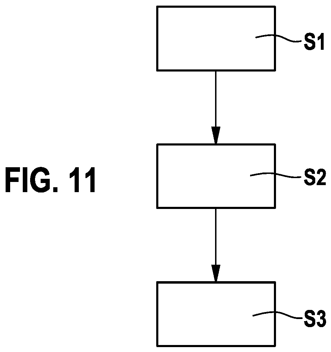

Figur 11 zeigt ein Verfahren zum Herstellen eines elektrischen Steckverbinders 2 aus elektrisch nicht leitfähigem Material mit einem Steckergehäuse 4 und wenigstens einem Steckkontakt 6 in einem Blockdiagramm. Das Steckergehäuse 4 besitzt eine im Wesentlichen zylindrische Innenwandung 8, wobei die Innenwandung 8 einen ersten Raum 10 begrenzt. Der Steckkontakt 6 besitzt ein von einem Gegensteckkontakt kontaktierbares erstes Ende 12 und ein dem ersten Ende 12 gegenüberliegendes zweites Ende 14. Das Verfahren besitzt folgende Verfahrensschritte: S1 stellt ein Verbinden des zweiten Endes 14 mit einer Leiterplatte 16 mittels Lot 20 in stoffschlüssiger Weise dar. Der Verfahrensschritt S2 stellt ein Verlagern des Steckergehäuses 4 von dem ersten Ende 12 in Richtung des zweiten Endes 14 über den wenigstens einen Steckkontakt 6 in eine vorbestimmte Position dar. Der Verfahrensschritt S3 stellt ein Verbinden der Leiterplatte 16 in der vorbestimmten Position mit dem Steckergehäuse 4 in fester Weise dar, wobei in der vorbestimmten Position das erste Ende 12 in den ersten Raum 10 ragt.

## Patentansprüche

1. Elektrischer Steckverbinder mit einem Steckergehäuse (4) aus elektrisch nicht-leitfähigem Material mit einer Innenwandung (8) und wenigstens einem Steckkontakt (6),
wobei die Innenwandung (8) einen ersten Raum (10) begrenzt,
wobei der Steckkontakt (6) ein von einem Gegensteckkontakt kontaktierbares erstes Ende (12) und ein dem ersten Ende (12) gegenüberliegendes zweites Ende (14) aufweist,
wobei das zweite Ende (14) mit einer Leiterplatte (16, 58) mittels Lot (18) verbunden ist,
wobei das Steckergehäuse (4) von dem ersten Ende (12) in Richtung des zweiten Endes (14) über den wenigstens einen Steckkontakt (6) in axialer Richtung in eine vorbestimmte Position verlagert ist,
wobei in der vorbestimmten Position die Leiterplatte (16, 58) fest mit dem Steckergehäuse (4) verbunden ist,
wobei in der vorbestimmten Position der Steckkontakt (6) quer zu der axialen Richtung fehlenden Kraftschluss aufweist,
wobei in der vorbestimmten Position das erste Ende (12) in den ersten Raum (10) ragt, **dadurch gekennzeichnet, dass**
entweder das Steckergehäuse (4) mittels einer Klebung (20) mit einer ersten Seite (17) der Leiterplatte (16, 58) fluiddicht unlösbar verbunden ist,
oder die Leiterplatte (16) innerhalb des ersten Raums (10) angeordnet und fluiddicht mit der Innenwandung (8) verbunden ist und ein umlaufendes zweites Dichtelement (78) zwischen der Leiterplatte (16) und einem Brückenelement (42) angeordnet ist, welches Brückenelement (42) an der Innenwandung (8) fest verbunden ist, wobei das Brückenelement (42) wenigstens eine sich in eine Längserstreckungsrichtung (L) des Steckkontakts (6) erstreckende Öffnung (48) aufweist, wobei der wenigstens eine Steckkontakt durch die wenigstens eine Öffnung geführt ist.

2. Elektrischer Steckverbinder nach Anspruch 1,
**dadurch gekennzeichnet, dass**
ein Brückenelement (42) an die Innenwandung (8) fest verbunden ist, wobei das Brückenelement (42) wenigstens eine sich in eine Längserstreckungsrichtung (L) des Steckkontakts (6) erstreckende Öffnung (48) aufweist,
wobei der wenigstens eine Steckkontakt durch die wenigstens eine Öffnung geführt ist, und der Steckkontakt (6) eine Verdickung (50) aufweist, wobei sich die Verdickung (50) an dem Brückenelement (42) derart abstützt, dass eine translatorische Bewegung des Steckkontakts (6) in Richtung des ersten Endes (12) verhindert ist.

3. Elektrischer Steckverbinder nach einem der vorhergehenden Ansprüche,
**dadurch gekennzeichnet, dass**
eine elektrische Leitung (40, 54) an die Leiterplatte (16) für eine elektrisch leitfähige Verbindung mit dem wenigstens einen Steckkontakt (6) unlösbar verbunden ist.

4. Elektrischer Steckverbinder nach einem der Ansprüche 1 bis 2,
**dadurch gekennzeichnet, dass**
eine elektrische Leitung (86) an den wenigstens einen Steckkontakt (6) elektrisch leitfähig unlösbar verbunden ist.

5. Elektrischer Steckverbinder nach einem der vorhergehenden Ansprüche,
**dadurch gekennzeichnet, dass**
das Steckergehäuse (4) eine der Innenwandung (8) gegenüberliegende Außenwandung (22) aufweist,
wobei an der Außenwandung (22) ein Aufnahmeelement (24) zur Aufnahme eines umlaufenden ersten Dichtelements (130) ausgebildet ist.

6. Anordnung mit einem Gehäuse (128) und einem elektrischen Steckverbinder (2) nach einem der Ansprüche 1 bis 5,
**dadurch gekennzeichnet, dass**
das Gehäuse (128) einen Innenraum (132) von einem das Gehäuse (128) umgebenden Außenraum (134) fluiddicht trennt,
wobei das Gehäuse (128) einen Durchbruch (126) aufweist,
wobei der elektrische Steckverbinder (2) in dem Durchbruch (126) angeordnet ist,
wobei das Gehäuse (128) und der Steckverbinder (2) durch das in dem Aufnahmeelement (24) der Außenwandung (22) umlaufende erste Dichtelement (130) miteinander fluiddicht verbunden sind.

7. Anordnung nach Anspruch 6,
**dadurch gekennzeichnet, dass**
das Gehäuse (128) einen Bund (154) aufweist,
wobei in dem Innenraum (132) eine technische Feder (148) angeordnet ist, wobei die technische Feder (148) und das Steckergehäuse (4) derart zusammenwirken, dass ein erster Schenkel (26) des Aufnahmeelements (24) an den Bund (154) gedrückt wird.

8. Automatikgetriebe für ein Kraftfahrzeug mit einem elektrischen Steckverbinder nach einem der Ansprüche 1 bis 5.

## Claims

1. Electrical plug-in connector with a plug housing (4) made of electrically non-conductive material, having an inner wall (8) and at least one plug-in contact (6), wherein the inner wall (8) delimits a first space (10), wherein the plug-in contact (6) has a first end (12) which can be contacted by a mating plug-in contact and a second end (14) which lies opposite the first end (12), wherein the second end (14) is connected to a printed circuit board (16, 58) by means of solder (18),
wherein the plug housing (4) is displaced, from the first end (12) in the direction of the second end (14), via the at least one plug-in contact (6), in an axial direction into a predetermined position,
wherein, in the predetermined position, the printed circuit board (16, 58) is fixedly connected to the plug housing (4),
wherein, in the predetermined position, the plug-in contact (6) has no force-fit action transversely with respect to the axial direction,
wherein, in the predetermined position, the first end (12) protrudes into the first space (10), **characterized in that**
either the plug housing (4) is connected to a first side (17) of the printed circuit board (16, 58) in a fluid-tight and non-releasable manner by means of a bond (20), or the printed circuit board (16) is arranged within the first space (10) and connected to the inner wall (8) in a fluid-tight manner and a circumferential second sealing element (78) is arranged between the printed circuit board (16) and a bridge element (42), which bridge element (42) is fixedly connected to the inner wall (8), wherein the bridge element (42) has at least one opening (48) which extends in a direction of longitudinal extent (L) of the plug-in contact (6), wherein the at least one plug-in contact is guided through the at least one opening.

2. Electrical plug-in connector according to Claim 1, **characterized in that**
a bridge element (42) is fixedly connected to the inner wall (8),
wherein the bridge element (42) has at least one opening (48) which extends in a direction of longitudinal extent (L) of the plug-in contact (6),
wherein the at least one plug-in contact is guided through the at least one opening, and the plug-in contact (6) has a thickened portion (50),
wherein the thickened portion (50) is supported on the bridge element (42) in such a way that a translational movement of the plug-in contact (6) in the direction of the first end (12) is prevented.

3. Electrical plug-in connector according to either of the preceding claims, **characterized in that**
an electrical line (40, 54) is connected in a non-releasable manner to the printed circuit board (16) for an electrically conductive connection to the at least one plug-in contact (6).

4. Electrical plug-in connector according to either of Claims 1 and 2, **characterized in that**
an electrical line (86) is connected to the at least one plug-in contact (6) in an electrically conductive and non-releasable manner.

5. Electrical plug-in connector according to one of the preceding claims, **characterized in that**
the plug housing (4) has an outer wall (22) which lies opposite the inner wall (8),
wherein a receiving element (24) for the reception of a circumferential first sealing element (130) is configured on the outer wall (22).

6. Arrangement having a housing (128) and an electrical plug-in connector (2) according to one of Claims 1 to 5, **characterized in that**
the housing (128) separates an inner space (132) from an outer space (134), which surrounds the housing (128), in a fluid-tight manner,
wherein the housing (128) has an aperture (126), wherein the electrical plug-in connector (2) is arranged in the aperture (126),
wherein the housing (128) and the plug-in connector (2) are connected to one another in a fluid-tight manner by the first sealing element (130) which runs around in the receiving element (24) of the outer wall (22).

7. Arrangement according to Claim 6,
**characterized in that**
the housing (128) has a collar (154),
wherein a technical spring (148) is arranged in the inner space (132),
wherein the technical spring (148) and the plug housing (4) interact in such a way that a first limb (26) of the receiving element (24) is pressed against the collar (154) .

8. Automatic transmission for a motor vehicle having an electrical plug-in connector according to one of Claims 1 to 5.

## Revendications

1. Connecteur enfichable électrique comprenant un boîtier de connecteur (4) en matériau électriquement non conducteur pourvu d'une paroi intérieure (8) et d'au moins un contact enfichable (6),
la paroi intérieure (8) délimitant un premier espace (10),
le contact enfichable (6) comportant une première extrémité (12) qui peut être contactée par un contact enfichable homologue et une deuxième extrémité (14) opposée à la première extrémité (12),
la deuxième extrémité (14) étant reliée à une carte de circuit imprimé (16, 58) au moyen d'une soudure (18),
le boîtier de connecteur (4) étant déplacé de la première extrémité (12) en direction de la deuxième extrémité (14) par le biais de l'au moins un contact enfichable (6) dans la direction axiale vers une position prédéterminée,
la carte de circuit imprimé (16, 58) étant reliée de manière fixe au boîtier de connecteur (4),
dans la position prédéterminée, le contact enfichable (6) ne comportant pas de liaison en force faisant défaut transversalement à la direction axiale,
dans la position prédéterminée, la première extrémité (12) faisant saillie dans le premier espace (10), **caractérisé en ce que**
soit le boîtier de connecteur (4) est connecté de manière inamovible et étanche aux fluides à un premier côté (17) de la carte de circuit imprimé (16, 58) au moyen d'un adhésif (20),
soit la carte de circuit imprimé (16) est disposée à l'intérieur du premier espace (10) et est reliée de manière étanche aux fluides à la paroi intérieure (8) et un deuxième élément d'étanchéité périphérique (78) est disposé entre la carte de circuit imprimé (16) et un élément de pontage (42), lequel élément de pontage (42) est relié de manière fixe à la paroi intérieure (8), l'élément de pontage (42) comportant au moins une ouverture (48) qui s'étend dans une direction d'extension longitudinale (L) du contact enfichable (6), l'au moins un contact enfichable étant guidé à travers l'au moins une ouverture.

2. Connecteur enfichable électrique selon la revendication 1,
**caractérisé en ce que**
un élément de pontage (42) est relié de manière fixe à la paroi intérieure (8),
l'élément de pontage (42) comportant au moins une ouverture (48) qui s'étend dans une direction d'extension longitudinale (L) du contact enfichable (6),
l'au moins un contact enfichable étant guidé à travers l'au moins une ouverture, et le contact enfichable (6) comportant un épaississement (50),
l'épaississement (50) venant en appui sur l'élément de pontage (42) de manière à empêcher un mouvement de translation du contact enfichable (6) en direction de la première extrémité (12).

3. Connecteur enfichable électrique selon l'une des revendications précédentes,
**caractérisé en ce que**
une ligne électrique (40, 54) est reliée de manière inamovible à la carte de circuit imprimé (16) pour établir une liaison électriquement conductrice avec l'au moins un contact enfichable (6).

4. Connecteur enfichable électrique selon l'une des revendications 1 et 2,
**caractérisé en ce que**
une ligne électrique (86) est reliée électriquement de manière inamovible à l'au moins un contact enfichable (6) .

5. Connecteur enfichable électrique selon l'une des revendications précédentes,
**caractérisé en ce que**
le boîtier de connecteur (4) comporte une paroi extérieure (22) opposée à la paroi intérieure (8),
un élément de réception (24) destiné à recevoir un premier élément d'étanchéité périphérique (130) étant formé sur la paroi extérieure (22).

6. Dispositif comprenant un boîtier (128) et un connecteur enfichable électrique (2) selon l'une des revendications 1 à 5,
**caractérisé en ce que**
le boîtier (128) sépare de manière étanche aux fluides un espace intérieur (132) d'un espace extérieur (134) entourant le boîtier (128),
le boîtier (128) comportant un passage (126),
le connecteur enfichable électrique (2) étant disposé dans le passage (126),
le boîtier (128) et le connecteur enfichable (2) étant reliés l'un à l'autre de manière étanche aux fluides par le premier élément d'étanchéité (130) périphérique dans l'élément de réception (24) de la paroi extérieure (22).

7. Dispositif selon la revendication 6,
**caractérisé en ce que**
le boîtier (128) comporte un collet (154),
un ressort technique (148) étant disposé dans l'espace intérieur (132),
le ressort technique (148) et le boîtier enfichable (4) coopérant de telle sorte qu'une première branche (26) de l'élément de réception (24) soit pressée sur le collet (154).

8. Boîte de vitesses automatique destinée à un véhicule automobile et pourvue d'un connecteur enfichable électrique selon l'une des revendications 1 à 5.
